# FASCICULE DE BREVET EUROPEEN

(11) **EP 1 079 525 B1**
(45) Date de publication et mention de la délivrance du brevet: **10.09.2008**
(21) Numéro de dépôt: 99117676.9
(22) Date de dépôt: 08.09.1999
(51) Int. Cl.: H03K 17/687

(54) **Système de commande d'un interrupteur bidirectionnel à deux transistors**
System zur Steuerung eines Zweirichtungs-Schalters mit zwei Transistoren
System for controlling a two-transistor bidirectional switch

(30) Priorité: 20.08.1999 CH 153099
(43) Date de publication de la demande: 28.02.2001
(73) Titulaire: EM Microelectronic-Marin SA, 2074 Marin (CH)
(72) Inventeur: Brülhart, Marcel, 1588 Cudrefin (CH); Trillat, Stephane, 2000 Neuchatel (CH)
(74) Mandataire: Ravenel, Thierry Gérard Louis

(56) Documents cités:
- EP-A- 0 525 744
- DE-A- 19 548 612
- US-A- 5 574 633
- US-A- 5 764 032

## Description

La présente invention est relative à un système de commande d'un interrupteur bidirectionnel pour circuits de contrôle de courant, notamment des circuits de contrôle de courant adaptés pour contrôler la charge et la décharge de batteries rechargeables. Plus particulièrement, la présente invention concerne un système de commande d'un interrupteur bidirectionnel formé d'une paire de transistors MOSFET de puissance connectés en anti-série, c'est-à-dire source à source ou drain à drain.

Des circuits permettant de contrôler la circulation bidirectionnelle d'un courant sont utilisés dans de nombreuses applications. De tels circuits sont notamment utilisés pour contrôler la charge et la décharge de batteries rechargeables (batteries au lithium, lithium-ions, etc.) assurant l'alimentation en énergie de dispositifs portatifs de divers types (téléphones, ordinateurs portables, pièces d'horlogerie, etc.).

Il est connu que les batteries rechargeables de ce type nécessitent une protection contre des conditions de fonctionnement inadéquates (surcharge ou surdécharge de la batterie, courants de charge ou de décharge trop importants, température de fonctionnement trop élevée, etc.) qui peuvent apparaître lorsque une charge ou un chargeur est connecté à la batterie ou lors d'un court-circuit des bornes de la batterie. Cette protection est nécessaire pour assurer que les performances de la batterie ne soient pas dégradées.

Ces circuits de contrôle de courant comportent ainsi typiquement des moyens d'interruption du courant placés en série dans le chemin du courant de la batterie et répondant à des signaux indicatifs des conditions de fonctionnement inadéquates, ceci afin d'interrompre la poursuite de la charge ou de la décharge de la batterie ou, de manière générale, afin d'interrompre la circulation d'un courant dans la batterie qui pourrait avoir un effet néfaste sur les performances de cette dernière. Ces moyens d'interruption du courant sont communément formés d'interrupteurs réalisés au moyen de transistors MOSFET de puissance et commandés par des circuits surveillant le niveau de charge ou de décharge de la batterie, la valeur du courant traversant celle-ci ou encore la température de la batterie.

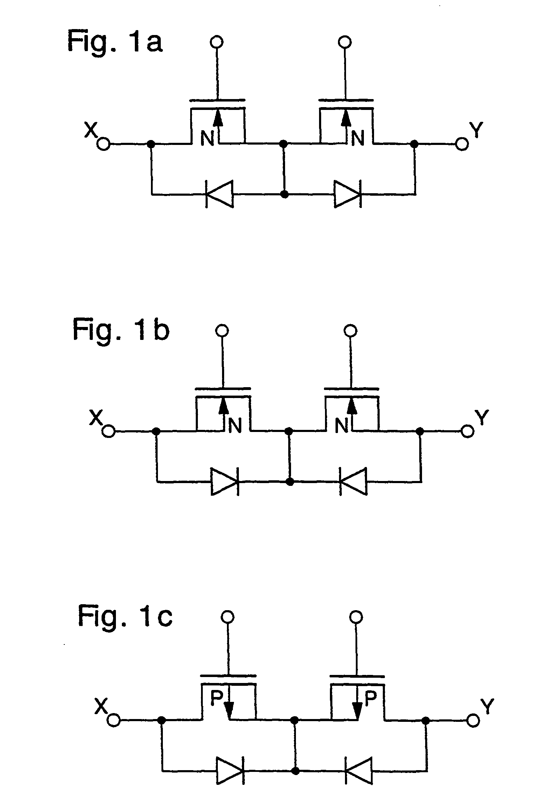

Dans de nombreuses applications, ces moyens d'interruption sont formés d'un interrupteur comprenant une paire de transistors MOSFET de puissance connectés en anti-série, c'est-à-dire source à source ou alternativement drain à drain. Les figures 1a à 1c illustrent trois exemples d'un tel interrupteur bidirectionnel à deux transistors. La figure 1a illustre une paire de transistors N-MOSFET connectés source à source, la figure 1b illustre une paire de transistors N-MOSFET connectés drain à drain, et la figure 1c illustre une paire de transistors P-MOSFET connectés source à source. Bien évidemment, une quatrième solution, non illustrée ici, consiste à connecter une paire de transistors P-MOSFET drain à drain. Ce type d'interrupteur est communément dénommé "interrupteur bidirectionnel" car il permet le blocage ainsi que la circulation d'un courant dans deux directions.

En fonctionnement normal, les deux transistors sont à l'état "ON" et un courant peut circuler dans les deux sens entre les bornes X et Y au travers de l'interrupteur. Lorsqu'une condition de fonctionnement inadéquate est détectée, l'un ou l'autre des transistors est mis à l'état "OFF" afin de bloquer la circulation du courant dans la batterie. On notera cependant que le courant peut toutefois circuler en sens inverse au travers d'une diode parasite ("body diode") formée entre le drain et la source de chaque transistor MOSFET de puissance, cette diode parasite étant due au fait que le substrat ("body") et la source du transistor de puissance sont mis au même potentiel.

Chaque transistor permet ainsi d'assurer le blocage unidirectionnel du courant tout en permettant le passage d'un courant de sens opposé au travers de sa diode parasite. Utilisés dans un circuit de contrôle de la charge et de la décharge de batteries rechargeables, l'un des transistors permet donc d'assurer l'interruption du courant de charge de la batterie, alors que l'autre transistor assure l'interruption du courant de décharge de sens opposé.

Deux facteurs sont déterminants lors du choix et de la réalisation d'un tel interrupteur bidirectionnel. On désire d'une part limiter autant que possible la valeur de la résistance série (ou résistance de conduction) R_{DS_ON} de l'interrupteur bidirectionnel. D'autre part, on désire minimiser autant que possible le temps de mise en conduction de l'interrupteur bidirectionnel.

Ces deux objectifs sont en fait intimement liés et opposés. En effet, afin de diminuer la résistance série R_{DS_ON} de l'interrupteur bidirectionnel, il convient de commander les transistors avec des tensions de grille relativement élevées, typiquement de l'ordre de 10 à 15 volts entre la grille et la source du transistor. Les transistors de puissance doivent ainsi quasiment instantanément aux conditions détectées.

Dans le document de brevet US 5,574,633, il est décrit un circuit électronique multi-phase à partage de charges entre plages d'entrée/sortie dudit circuit pour réduire le temps d'un changement d'état de signaux de données sur lesdites plages. Des lignes de bus de données sont reliées chacune à des plages d'entrée/sortie de signaux de données du circuit. Comme d'importantes capacités sont définies par ces plages d'entrée/sortie, il est prévu de coupler momentanément au moins deux plages par un moyen de couplage pour faire passer rapidement une des plages d'un premier état, par exemple un état "0", à un second état, par exemple un état "1" de l'autre plage. Cependant, ce circuit électronique n'est pas destiné à commander un interrupteur bidirectionnel.

Un but de la présente invention est ainsi de proposer un système de commande d'un interrupteur bidirectionnel à deux transistors permettant notamment de répondre aux deux objectifs opposés susmentionnés.

A cet effet, la présente invention a pour objet un système de commande d'un interrupteur bidirectionnel à deux transistors, dont les caractéristiques sont énoncées à la revendication 1.

La présente invention a en outre pour objet un procédé de commande d'un interrupteur bidirectionnel à deux transistors, dont les caractéristiques sont énoncées à la revendication 5.

Selon la présente invention, on tire avantageusement parti du fait que l'interrupteur bidirectionnel est composé de deux transistors de puissance montés en anti-série et que seul l'un des transistors est mis à l'état "OFF" lorsque l'on désire interrompre la circulation du courant au travers de la batterie, l'autre transistor restant toujours à l'état "ON".

En couplant au moins temporairement les grilles des transistors de puissance lors de la remise en conduction du transistor à l'état "OFF", les charges présentes sur le transistor resté à l'état "ON" sont partagées avec l'autre transistor et il est ainsi possible de diminuer sensiblement le temps de remise en conduction de ce transistor. Il est ainsi possible d'améliorer les caractéristiques dynamiques de l'interrupteur bidirectionnel, à savoir essentiellement son temps de mise en conduction, malgré l'utilisation de tensions de grilles élevées permettant d'obtenir une faible résistance série de l'interrupteur.

D'autres caractéristiques et avantages de l'invention apparaîtront plus clairement à la lecture de la description détaillée qui suit, faite en référence aux dessins annexés donnés à titre d'exemples non limitatifs et dans lesquels :
- les figures 1a à 1c déjà présentées illustrent trois exemples connus de réalisation d'un interrupteur bidirectionnel à deux transistors;
- la figure 2 illustre un exemple schématique d'un circuit de contrôle de courant ou circuit de protection d'une batterie rechargeable;
- la figure 3 illustre un schéma de principe du système de commande d'un interrupteur bidirectionnel à deux transistors selon la présente invention;
- la figure 4 illustre un exemple de réalisation en technologie CMOS basse tension d'un système de commande d'un interrupteur bidirectionnel à deux transistors selon la présente invention; et
- les figures 5a à 5d illustrent un ensemble de diagrammes de l'évolution des tensions de commande du système de commande illustré à la figure 4, permettant de mettre en évidence les effets bénéfiques de la présente invention.

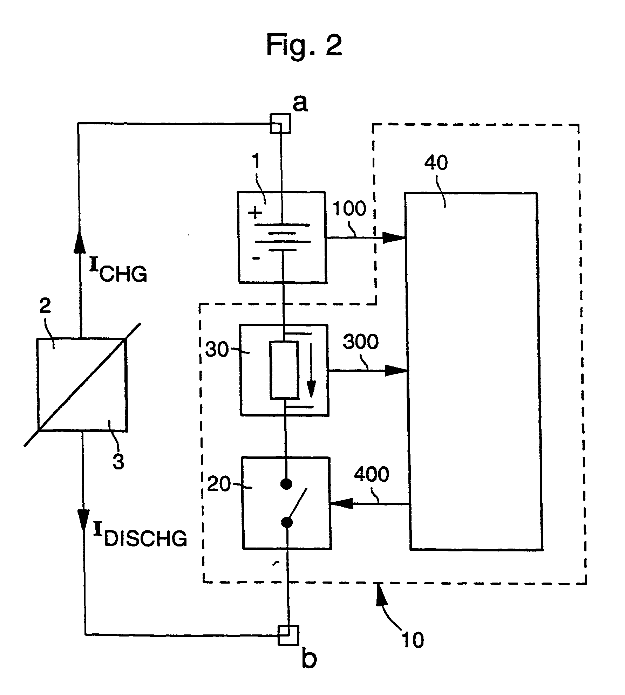

En référence à la figure 2, il est illustré de manière schématique un circuit de protection 10 d'une batterie rechargeable 1. La batterie 1 et le circuit de protection 10 forment un ensemble comportant deux bornes a et b entre lesquelles peuvent être connectées une charge 2 ou un chargeur 3.

Le circuit de protection, pouvant être dénommé plus généralement le circuit de contrôle de courant 10, comporte des moyens d'interruption du courant, formés d'un interrupteur bidirectionnel 20, et éventuellement des moyens de mesure du courant 30 disposés en série avec la batterie 1 entre les bornes a et b de l'ensemble. Ainsi, lorsqu'une charge 2 est connectée entre les bornes a et b de l'ensemble, un courant de décharge I_{DISCHG} circule de la borne positive de la batterie 1 via la charge 2 et l'interrupteur bidirectionnel 20 jusqu'à la borne négative de la batterie 1. Lorsqu'un chargeur 3 est connecté entre les bornes a et b de l'ensemble, un courant de charge I_{CHG} circule alors dans le sens opposé au courant de décharge I_{DISCHG}.

On notera que les moyens de mesure 30 peuvent être réalisés sous la forme d'une résistance de mesure fournissant une chute de potentiel représentative du courant la traversant. L'interrupteur bidirectionnel 20 peut toutefois également former les moyens de mesure 30. Dans ce cas, la tension aux bornes de l'interrupteur bidirectionnel 20 est utilisée pour évaluer la valeur du courant de charge I_{CHG} ou de décharge I_{DISCHG} traversant la batterie 1.

Le circuit de contrôle de courant 10 comporte en outre des moyens de détection et de commande 40 couplés à la batterie 1 et, le cas échéant, aux moyens de mesure 30. Les moyens de détection et de commande 40 reçoivent de la batterie 1 et des moyens de mesure 30 des signaux de détection 100 et 300 respectivement représentatifs du niveau de charge de la batterie 1 et de la valeur du courant traversant la batterie 1. En réponse à ces signaux de détection 100 et 300, les moyens de détection et de commande 40 fournissent un ou plusieurs signaux de commande 400 à l'interrupteur bidirectionnel 20. On ne décrira pas en détail ici comment sont réalisés ces moyens de détection et de commande 40. Il suffit de mentionner ici que ces moyens comprennent typiquement, d'une part, des moyens de détection et de comparaison permettant notamment de comparer la tension aux bornes de la batterie à différents niveaux de tension de référence et de fournir, en réponse, des signaux d'activation de niveau logique, et, d'autre part, des moyens de commande répondant à ces signaux d'activation et formant à proprement parler le système de commande de l'interrupteur bidirectionnel 20.

Dans la suite de la présente description, on s'attardera essentiellement sur la description de ce système de commande de l'interrupteur bidirectionnel 20.

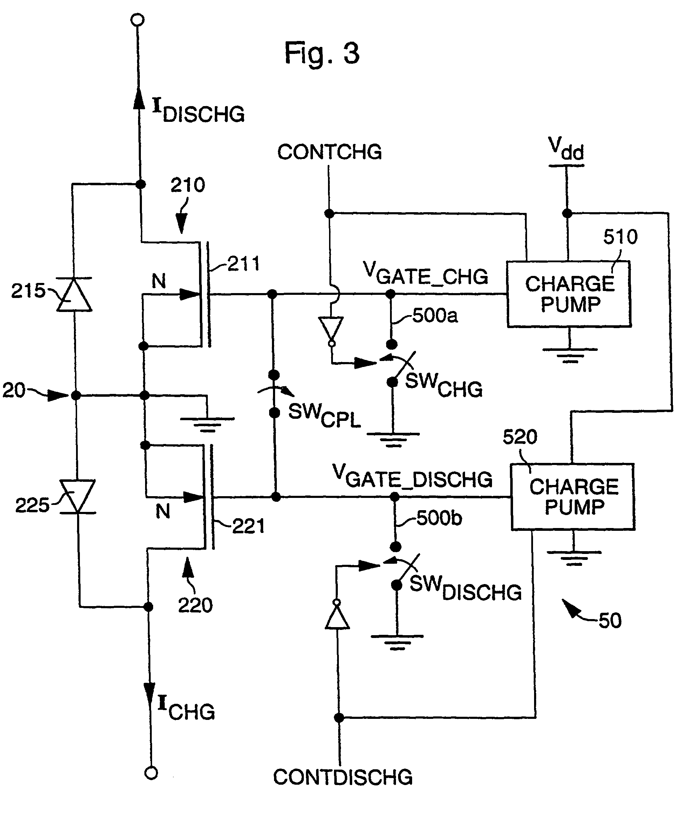

Le principe de fonctionnement du système de commande selon la présente invention sera maintenant décrit en référence à la figure 3. Cette figure illustre le schéma de principe du système de commande d'un interrupteur bidirectionnel à deux transistors MOSFET de puissance selon la présente invention.

L'interrupteur bidirectionnel 20 illustré dans cette figure est formé dans cet exemple d'une paire de transistors N-MOSFET de puissance 210 et 220 connectés source à source. Chacun des transistors de puissance 210 et 220 comporte une diode parasite ("body diode") 215, 225 formée entre le drain et la source des transistors en parallèle avec le canal. Les drains des transistors de puissance 210 et 220 sont connectés conformément à ce qui a été décrit précédemment de manière à ce que l'interrupteur bidirectionnel soit disposé dans le chemin du courant dont la circulation doit, le cas échéant, être interrompue.

Dans l'exemple d'application utilisé ici à titre non limitatif, l'interrupteur bidirectionnel 20 étant disposé en série dans le chemin du courant de la batterie (non représentée dans cette figure), un premier courant, à savoir un courant de charge I_{CHG}, est susceptible de circuler au travers de l'interrupteur bidirectionnel 20 comme cela est indiqué par la direction de la flèche dans la figure, et un second courant de sens opposé au premier courant, à savoir un courant de décharge I_{DISCHG}, est susceptible de circuler au travers de l'interrupteur bidirectionnel 20 comme cela est indiqué par la direction de l'autre flèche.

Les grilles 211 et 221 des transistors de puissance 210 et 220 sont respectivement connectées à des moyens de commande 50 délivrant des première et seconde tension de grille V_{GATE_CHG} et V_{GATE_DISCHG} aux grilles 211 et 221, respectivement, des transistors de puissance 210 et 220. Lorsque l'une ou l'autre de ces tensions de grille V_{GATE_CHG} et V_{GATE_DISCHG} est sensiblement égale à la tension présente au noeud formé par les sources des transistors 210 et 220, ici la masse, le transistor de puissance correspondant est rendu non conducteur, c'est-à-dire mis à l'état "OFF". Afin de remettre ces transistors à l'état "ON", la tension de grille est amenée à un niveau tel que la tension entre la grille et la source du transistor soit supérieure à la tension de seuil (typiquement de 0.7 à 2.5 volts) de ce transistor.

Préférablement, comme cela a déjà été mentionné en préambule de cette description, afin de réduire la valeur de la résistance série R_{DS_ON} (ou résistance de conduction) de chacun des transistors de puissance 210 et 220, les tensions de grille V_{GATE_CHG} et V_{GATE_DISCHG} sont préférablement amenées à des niveaux tels que la tension grille-source de chacun des transistors soit sensiblement supérieure à la tension de seuil (typiquement 5 à 15 volts au-dessus de la tension de seuil). Pour ce faire, les moyens de commande 50 comprennent préférablement deux pompes de charge 510 et 520 respectivement connectées aux grilles 211 et 221 des transistors MOSFET de puissance 210 et 220. Ces pompes de charge sont largement répandues et permettent de produire une tension de sortie plus élevée que leur tension d'entrée. Typiquement, ces pompes de charge sont adaptées pour doubler ou tripler leur tension d'entrée. On notera que l'on connaît également ce type de dispositifs sous la dénomination doubleur de tension ou tripleur de tension. Dans l'exemple d'application utilisé ici, on mentionnera que les pompes de charge sont ainsi typiquement adaptées pour tripler une tension d'entrée V_{dd} définie comme la tension de la batterie rechargeable.

Comme cela est illustré dans la figure 3, deux interrupteurs de blocage SW_{CHG} et SW_{DISCHG} disposés respectivement dans des première et seconde branches 500a et 500b permettent de connecter chacune des grilles 211 et 221 à la masse afin de mettre, le cas échéant, le transistor de puissance correspondant à l'état "OFF". On mentionnera toutefois qu'il est parfaitement envisageable de prévoir additionnellement ou alternativement que les pompes de charge 510 et 520 soient désactivées lorsque le transistor correspondant doit être mis à l'état "OFF". Les interrupteurs de blocage SW_{CHG} et SW_{DISCHG} peuvent ainsi être directement intégrés aux pompes de charge 510 et 520.

Selon une caractéristique essentielle de la présente invention, les moyens de commande 50 comprennent en outre un moyen de couplage connecté entre les grilles 211 et 221 des transistors MOSFET de puissance 210 et 220. Ce moyen de couplage peut aisément être réalisé sous la forme d'un interrupteur de couplage SW_{CPL} adapté pour connecter les grilles 211 et 221 des transistors de puissance comme cela est illustré dans la figure 3.

Selon la présente invention, cet interrupteur de couplage SW_{CPL} est adapté pour coupler au moins temporairement les grilles 211 et 221 des transistors de puissance 210 et 220 lorsque l'un ou l'autre de ces transistors, qui avait préalablement été mis à l'état "OFF" pour interrompre la circulation d'un courant, doit être remis à l'état "ON".

En couplant au moins temporairement les grilles 211 et 221 des transistors MOSFET de puissance 210 et 220 lors de la remise en conduction du transistor à l'état "OFF", les charges présentes sur la grille du transistor resté à l'état "ON" sont partagées avec l'autre transistor et il est ainsi possible de diminuer sensiblement le temps de remise en conduction de ce transistor et par là même le temps de mise en conduction ou temps de commutation à l'état "ON" de l'interrupteur bidirectionnel 20. Selon la présente invention, on tire donc avantageusement parti du fait que seul l'un des transistors MOSFET de puissance 210 ou 220 est mis à l'état "OFF" lorsque l'on désire interrompre la circulation du courant au travers de la batterie, l'autre transistor restant toujours à l'état "ON".

Afin de profiter de ce fait, il convient de connecter au moins temporairement les grilles des transistors de puissance durant un intervalle de temps suffisant pour que le transistor de puissance qui était à l'état "OFF" redevienne conducteur. On comprendra toutefois que les grilles des transistors MOSFET de puissance 210 et 220 peuvent parfaitement être couplées ensemble en permanence tant qu'il est désirable de maintenir les deux transistors à l'état "ON". Bien évidemment, ce moyen de couplage doit obligatoirement être adapté pour découpler les grilles des transistors lorsque l'un des transistors de puissance 210 ou 220 de l'interrupteur bidirectionnel 20 doit être rendu non conducteur.

Dans le principe, on comprendra que l'interrupteur de couplage SW_{CPL} formant le moyen de couplage peut être commandé par un signal de commande formé d'une combinaison logique des signaux d'activation commandant respectivement les interrupteurs SW_{CHG} et SW_{DISCHG}. Ainsi si l'on admet que des signaux d'activation CONTCHG et CONTDISCHG sont utilisés pour commander respectivement les interrupteurs SW_{CHG} et SW_{DISCHG}, ces signaux d'activation étant à l'état logique "haut" lorsque les transistors de puissance doivent être mis à l'état "ON", le signal de commande de l'interrupteur de couplage SW_{CPL} peut être défini comme la combinaison logique ET de ces signaux d'activation CONTCHG et CONTDISCHG.

On mentionnera que les interrupteurs SW_{CHG}, SW_{DISCHG} et SW_{CPL} doivent être adaptés pour commuter entre des tensions relativement élevées (de l'ordre de la tension de grille appliquée au transistors de puissance 210 et 220, soit plus d'une dizaine de volts). Il est envisageable de réaliser ces interrupteurs au moyen de transistors MOSFET adaptés pour résister à de telles tensions de commutation. Toutefois, on comprendra que le temps de réponse de l'interrupteur de couplage SW_{CPL} est déterminant pour la durée de commutation à l'état "ON" de l'interrupteur bidirectionnel 20. Il est donc préférable de minimiser le temps de commutation à l'état "ON" de l'interrupteur de couplage SW_{CPL}, c'est-à-dire utiliser des transistors MOSFET basse tension possédant une faible capacité de grille.

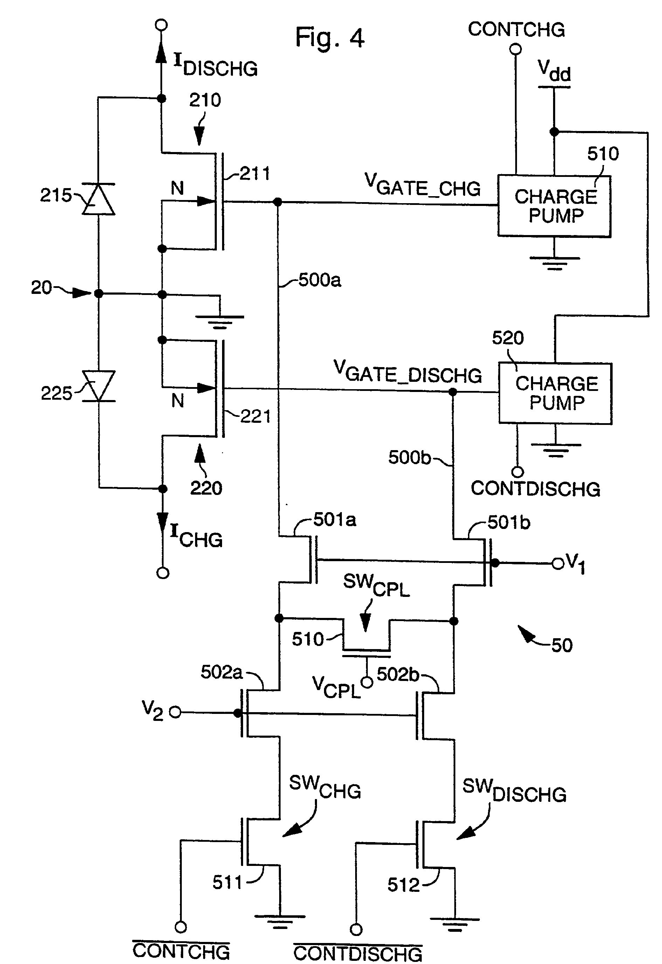

Afin de réaliser le système de commande selon la présente invention en technologie CMOS basse tension, il faudra donc apporter quelques modifications au système qui vient d'être décrit. La figure 4 illustre un mode de réalisation d'un système de commande d'un interrupteur bidirectionnel à deux transistors réalisé en technologie CMOS basse tension. Des références numériques identiques ont été utilisées dans cette figure pour désigner les éléments communs à ce mode de réalisation et au schéma de principe de la figure 3.

En se référant à la figure 4, l'interrupteur bidirectionnel 20 formé de la paire de transistors N-MOSFET de puissance 210 et 220 est ainsi commandé par les moyens de commande 50 comportant notamment les pompes de charge 510 et 520 fournissant respectivement des tensions de grille V_{GATE_CHG} et V_{GATE_DISCHG} équivalentes, dans ce mode de réalisation, à trois fois la tension d'entrée V_{dd} fournie par la batterie.

Selon ce mode de réalisation, la première branche 500a comprenant l'interrupteur de blocage SW_{CHG} permet de tirer à la masse la grille 211 du transistor MOSFET de puissance 210 afin de le mettre à l'état "OFF". De même, la seconde branche 500b comprenant l'interrupteur de blocage SW_{DISCHG} permet de tirer à la masse la grille 221 du transistor MOSFET de puissance 220 afin de mettre ce dernier à l'état "OFF". Les interrupteurs de blocage SW_{CHG} et SW_{DISCHG} sont formés de transistors MOSFET 511 et 512, respectivement, dont l'une des bornes est connectée à la masse. Les grilles de ces transistors MOSFET 511 et 512 sont respectivement commandées par les signaux d'activation CONTCHG et CONTDISCHG inversés.

Les branches 500a et 500b comprennent en outre chacune des premier et second transistors de protection 501a et 502a, respectivement 501b et 502b, connectés en série entre la grille du transistor MOSFET de puissance correspondant et l'interrupteur de blocage correspondant, à savoir respectivement entre la grille 211 du transistor de puissance 210 et l'interrupteur SW_{CHG} d'une part, et entre la grille 221 du transistor de puissance 220 et l'interrupteur SW_{DISCHG} d'autre part.

Les grilles des premiers transistors de protection 501a et 501b sont connectées ensemble et commandées par une première tension de commande V₁. Les grilles des seconds transistors de protection 502a et 502b sont connectées ensemble et commandées par une seconde tension de commande V₂.

L'interrupteur de couplage SW_{CPL}, formé dans cet exemple d'un transistor MOSFET de couplage 510, est connecté entre le noeud de connexion des premier et second transistors de protection 501a et 502a de la première branche 500a, et le noeud de connexion des premier et second transistors de protection 501b et 502b de la seconde branche 500b. La grille du transistor de couplage 510 formant l'interrupteur de couplage est commandée par une tension de commande V_{CPL} représentative des signaux d'activation CONTCHG et CONTDISCHG des interrupteurs de blocage SW_{CHG} et SW_{DISCHG}. Dans ce mode de réalisation, cette tension de commande V_{CPL} vaut sensiblement 0 de manière à découpler les grilles 211 et 221 des transistors de puissance 210 et 220 lorsque l'un des signaux d'activation CONTCHG et CONTDISCHG signale que l'un de ces transistors de puissance doit être mis à l'état "OFF". Au contraire, afin de coupler les grilles 211 et 221 des transistors de puissance 210 et 220 de manière à permettre un enclenchement rapide du transistor bloqué, la tension de commande V_{CPL} de la grille du transistor de couplage 510 est amenée à une valeur sensiblement égale à la tension de grille des transistors de puissance 210 et 220.

Afin d'assurer qu'aucun des transistors composant les moyens de commande 50 ne voit une tension trop élevée à ses bornes, les grilles de premiers transistors de protection 501a et 501b ainsi que les grilles des seconds transistors de protection 502a et 502b sont commandées de la manière suivante.

En fonctionnement normal, c'est-à-dire lorsque les deux transistors MOSFET de puissance 210 et 220 formant l'interrupteur bidirectionnel 20 sont à l'état "ON" (CONTCHG = CONTDISCHG = "1"), la première tension de commande V₁ des premiers transistors de protection 501a et 501b est amenée à une valeur sensiblement égale à la tension de grille des transistors de puissance 210 et 220, c'est-à-dire environ trois fois la tension d'entrée V_{dd}. La seconde tension de commande V₂ des seconds transistors de protection 502a et 502b est quant à elle amenée à une valeur sensiblement égale à deux fois la tension d'entrée V_{dd}.

Lorsque l'un ou l'autre des transistors MOSFET de puissance 210 ou 220 doit être mis à l'état "OFF" afin d'interrompre la circulation d'un courant au travers de l'interrupteur bidirectionnel 20 (CONTCHG = "0" ou CONTDISCHG = "0"), la première tension de commande V₁ est réduite à une tension sensiblement égale à deux fois la tension d'entrée V_{dd}, alors que la seconde tension de commande V₂ est quant à elle réduite à une tension sensiblement égale à la tension d'entrée V_{dd}.

Ce procédé de commande des grilles des interrupteurs de protection 501a, 502a, 501b et 502b permet ainsi d'assurer qu'aucun des transistors ne voit une tension trop élevée à ses bornes, qui pourrait entraîner un claquage de ce dernier.

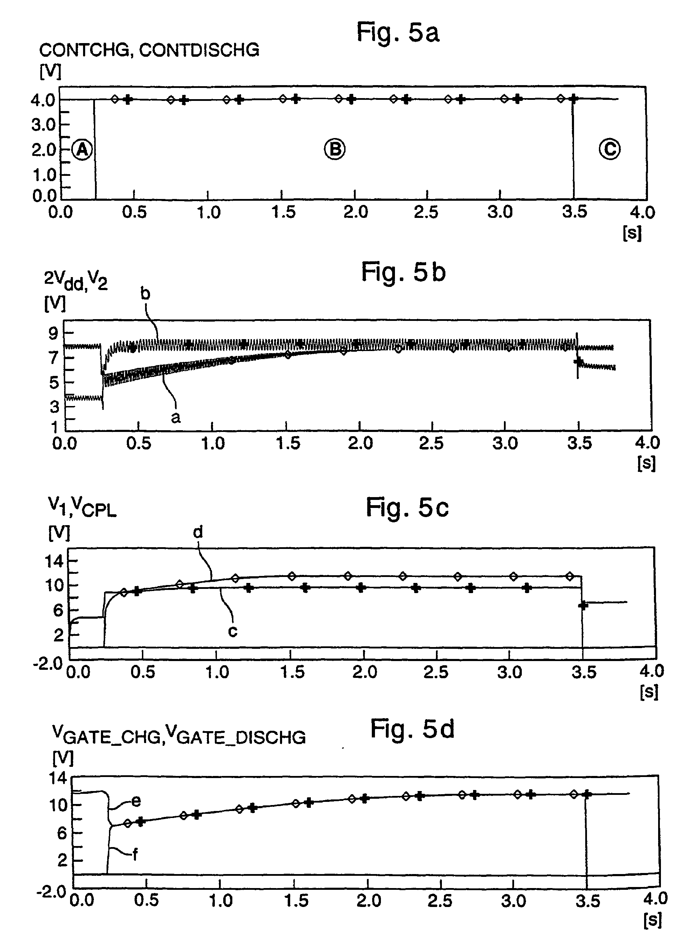

Les figures 5a à 5d illustrent quatre diagrammes d'évolution des diverses tensions de commande du système de commande de la figure 4 en réponse aux signaux d'activation CONTCHG et CONTDISCHG, permettant de mettre en évidence les effets bénéfiques de la présente invention. On a représenté ici une situation où l'interrupteur bidirectionnel bloque, dans un premier temps (phase A dans les figures), la poursuite la décharge de la batterie (CONTCHG = "1", CONTDISCHG = "0"), puis, dans un deuxième temps (phase B), est remis en fonctionnement normal (CONTCHG = CONTDISCHG = "1"), et, dans un troisième temps (phase C), bloque à nouveau la poursuite de la décharge (CONTCHG = "1", CONTDISCHG = "0").

La figure 5a présente ainsi un premier diagramme dans lequel sont illustrés les signaux d'activation CONTCHG et CONTDISCHG. La figure 5b présente un second diagramme dans lequel sont illustrées une première courbe a représentative de l'évolution du double de la tension V_{dd} fournie par la batterie et une seconde courbe b représentative de l'évolution de la seconde tension de commande V₂ des seconds transistors de protection 502a et 502b de la figure 4. La figure 5c présente un troisième diagramme dans lequel sont illustrées une troisième courbe c représentative de l'évolution de la première tension de commande V₁ des premiers transistors de protection 501a et 501b de la figure 4, et une quatrième courbe d représentative de l'évolution de la tension de commande V_{CPL} du transistor de couplage 510. La figure 5d présente quant à elle un quatrième diagramme dans lequel sont illustrées des cinquième et sixième courbes e et f respectivement représentatives de l'évolution des tensions de grille V_{GATE_CHG} et V_{GATE_DISCHG} des transistors MOSFET de puissance 210 et 220.

On constate ainsi dans ces figures qu'au cours de la phase A et de la phase C (CONTCHG = "1", CONTDISCHG = "0"), la tension de grille V_{GATE_DISCHG} du transistor MOSFET de puissance 220 est sensiblement égale à 0 de sorte que ce transistor est mis à l'état "OFF" afin d'interrompre toute poursuite de la décharge de la batterie. Le transistor MOSFET de puissance 210 est maintenu à l'état "ON" par l'application de la tension de grille V_{GATE_CHG} équivalente à environ trois fois la tension V_{dd}. Les première et seconde tensions de commande V₁ et V₂ valent dans ce cas, comme cela a déjà été mentionné, environ deux et respectivement une fois la tension V_{dd}. La tension de commande V_{CPL} du transistor de couplage 510 est quant à elle maintenue sensiblement à 0 de sorte que les grilles des transistors MOSFET de puissance 210 et 220 de la figure 4 sont maintenues découplées.

Lors de la transition à la phase B (CONTCHG = CONTDISCHG = "1"), la tension de commande V_{CPL} du transistor de couplage 510 passe à environ trois fois la tension V_{dd} de sorte que les grilles des transistors MOSFET de puissance 210 et 220 sont couplées. Simultanément, les première et seconde tensions de commande V₁ et V₂ des transistors de protection passent respectivement à trois et deux fois la tension V_{dd}. Comme cela ressort du diagramme de la figure 5d, il s'ensuit que les charges présentes sur la grille du transistor MOSFET de puissance 210 resté à l'état "ON" sont partagées avec le transistor MOSFET de puissance 220. La grille du transistor MOSFET de puissance 220 est ainsi très rapidement chargée à un niveau suffisant pour le rendre conducteur par le transfert d'une partie des charges du transistor MOSFET de puissance 210 resté à l'état "ON". Le seuil de conduction des transistors MOSFET de puissance se situant à environ 1 volt, on constate ainsi que le transistor MOSFET de puissance 220 est mis à l'état "ON" pratiquement instantanément. Une fois les grilles couplées, la charge des grilles des transistors MOSFET de puissance représentée par les courbes e et f de la figure 5d suit une évolution normale.

Tout ce qui vient d'être décrit est bien évidemment applicable de manière similaire dans la situation où l'interrupteur bidirectionnel bloque la poursuite de la charge de la batterie, c'est-à-dire la situation où le transistor MOSFET de puissance 210 est mis à l'état "OFF" (CONTCHG = "0", CONTDISCHG = "1").

On comprendra en outre aisément que le système de commande selon la présente invention peut faire l'objet de nombreuses modifications et/ou améliorations sans sortir du cadre des revendications. En particulier, l'homme du métier est parfaitement à même de modifier le système de commande selon la présente invention pour l'adapter à des tensions de commande plus faibles ou plus élevées selon l'application. On rappellera par ailleurs que le système de commande d'un interrupteur bidirectionnel selon la présente invention est également applicable à d'autres circuits que les circuits de protection pour batterie qui ont été pris ici comme exemples.

## Revendications

1. Système de commande d'un interrupteur bidirectionnel (20) formé d'une paire de transistors MOSFET de puissance (210, 220) montés en anti-série source à source ou drain à drain, ce système de commande comprenant des moyens de commande (50) destinés à commander l'état de conduction desdits transistors de puissance (210, 220) reliés aux moyens de commande, l'un ou l'autre de ces transistors de puissance étant susceptible d'être mis à l'état "OFF" par les moyens de commande afin d'assurer l'interruption d'un courant (I_{CHG}, I_{DISCHG}) au travers dudit interrupteur (20), les moyens de commande comprenant en outre un moyen de couplage (SW_{CPL}, 510) destiné à relier au moins temporairement la grille (211; 221) d'un transistor de l'interrupteur à l'état "ON" avec la grille (221, 211) d'un transistor de l'interrupteur à l'état "OFF" lors de l'enclenchement dudit interrupteur (20), ou destiné à relier en permanence les grilles des transistors de l'interrupteur lorsqu'ils sont commandés à l'état "ON", les moyens de commande (50) comprenant également des première et seconde branches (500a, 500b) destinées à être respectivement connectées aux grilles (211, 221) desdits transistors de puissance (210, 220) de l'interrupteur et comprenant chacune un interrupteur de blocage (SW_{CHG}, SW_{DISCHG}; 511, 512) permettant de mettre à l'état "OFF" le transistor de puissance (210, 220) correspondant, **caractérisé en ce que** chacune desdites branches (500a, 500b) comporte en outre des premier (501 a, 501 b) et second (502a, 502b) transistors de protection connectés en série entre la grille (211, 221) du transistor de puissance (210, 220) correspondant et l'interrupteur de blocage (SW_{CHG}, SW_{DISCHG}; 511, 512), ledit moyen de couplage (SW_{CPL}, 510) étant connecté entre le noeud de connexion des premier et second transistors de protection (501 a, 502a) de la première branche (500a), et le noeud de connexion des premier et second transistors de protection (501b, 502b) de la seconde branche (500b)..

2. Système de commande selon la revendication 1, **caractérisé en ce que** lesdits moyens de commande (50) comprennent deux pompes de charge (510, 520) destinées à être respectivement connectées aux grilles (211, 221) desdits transistors de puissance (210, 220).

3. Système de commande selon la revendication 1, **caractérisé en ce que** lesdits interrupteurs de blocage (SW_{CHG}, SW_{OISCHG}; 511, 512) sont des transistors MOSFET.

4. Système de commande selon l'une quelconque des revendications précédentes, **caractérisé en ce que** ledit moyen de couplage est un transistor MOSFET.

5. Procédé de commande d'un interrupteur bidirectionnel (20) formé d'une paire de transistors MOSFET de puissance (210, 220) montés en anti-série source à source ou drain à drain et commandés par des moyens de commande (50) d'un système de commande selon l'une des revendications précédentes, l'un ou l'autre desdits transistors de puissance (210, 220) étant susceptible d'être mis à l'état "OFF" afin d'assurer l'interruption d'un courant (I_{CHG}, I_{DISCHG}) au travers dudit interrupteur (20), dans lequel, lors de l'enclenchement dudit interrupteur (20), la grille (211; 221) du transistor à l'état "ON" est au moins temporairement reliée avec la grille (221; 211) du transistor à l'état "OFF".

6. Procédé de commande selon la revendication 5, dans lequel les grilles (211, 221) desdits transistors de puissance (210, 220) sont reliées en permanence lorsque ceux-ci sont à l'état "ON".

## Claims

1. Control system for a bidirectional switch (20) formed of a pair of MOFSET power transistors (210, 220) mounted in anti-series source to source or drain to drain, this control system including control means (50) allowing the state of conduction of said power transistors (210, 220) to be controlled connected to the control means, one or the other of said power transistors being able to be set to the " OFF " state by the control means in order to assure the interruption of a current (I_{CHG}, I_{DISCHG}) through said switch (20), the control means further including coupling means (SW_{CPL}, 510) enabling the gate (211; 221) of one transistor of the switch at the " ON " state to be coupled at least temporarily with the gate (221, 211) of one transistor of the switch at the " OFF " state when said switch (20) is switched on, or permanently couples the gates of the switch transistors when the latter are at the " ON " state, the control means (50) including also first and second branches (500a, 500b) respectively connected to the gates (211, 221) of said power transistors (210, 220) of the switch and each including a blocking switch (SW_{CHG}, SW_{DISCHG}; 511, 512) enabling the corresponding power transistor (210, 220) to be set to the " OFF " state, **characterized in that** each of said branches (500a, 500b) further includes first (501 a, 501 b) and second (502a, 502b) protective transistors connected in series between the gate (211, 221) of the corresponding power transistor (210, 220) and the blocking switch (SW_{CHG}, SW_{DISCHG}; 511, 512), said coupling means (SW_{CPL}, 510) being connected between the connection node of the first and second protective transistors (501 a, 502a) of the first branch (500a), and the connection node of the first and second protective transistors (501 b, 502b) of the second branch (500b).

2. Control system according to claim 1, **characterized in that** said control means (50) include two charge pumps (510, 520) respectively connected to the gates (211, 221) of said power transistors (210, 220).

3. Control system according to claim 1, **characterized in that** said blocking switches (SW_{CHG}, SW_{DISCHG}; 511, 512) are MOFSET transistors.

4. Control system according to any one of the preceding claims, **characterized in that** said coupling means are a MOFSET transistor.

5. Control method for a bidirectional switch (20) formed of a pair of MOFSET power transistors (210, 220) mounted in anti-series source to source or drain to drain, and controlled by control means (50) of a control system according to any one of the preceding claims, one or the other of said power transistors (210, 220) being able to be set to the " OFF " state in order to assure the interruption of a current (I_{CHG}, I_{DISCHG}) through said switch (20), wherein, when said switch (20) is switched on, the gate (211; 221) of the power transistor at the " ON " state is at least temporarily coupled with the gate (221, 211) of the power transistor at the " OFF " state.

6. Control method according to claim 5, wherein the gates (211, 221) of said power transistors (210, 220) are permanently coupled when the latter are at the " ON " state.

## Patentansprüche

1. System zum Steuern eines bidirektionalen Unterbrechers (20), der aus einem Paar von Leistungs-MOSFET-Transistoren (210, 220), die in Antireihe, Source mit Source oder Drain mit Drain, geschaltet sind, gebildet ist, wobei dieses Steuersystem Steuermittel (50) umfasst, die dazu vorgesehen sind, den Durchschaltzustand der Leistungstransistoren (210, 220), die mit den Steuermitteln verbunden sind, zu steuern, wobei der eine oder der andere dieser Leistungstransistoren durch die Steuermittel in den "AUS"-Zustand versetzt werden kann, um die Unterbrechung eines Stroms (I_{CHG}, I_{DISCHG}) durch den Unterbrecher (20) sicherzustellen, wobei die Steuermittel außerdem ein Kopplungsmittel (SW_{CPL}, 510) umfassen, das dazu vorgesehen ist, wenigstens vorübergehend das Gate (211; 221) eines Unterbrechertransistors im "EIN"-Zustand mit dem Gate (221, 211) eines Unterbrechertransistors im "AUS"-Zustand zu verbinden, wenn der Unterbrecher (20) ausgelöst wird, oder dazu vorgesehen ist, die Gates der Unterbrechertransistoren ständig zu verbinden, wenn sie in den "EIN"-Zustand gesteuert sind, wobei die Steuermittel (50) außerdem einen ersten und einen zweiten Zweig (500a, 500b) umfassen, die dazu vorgesehen sind, jeweils mit den Gates (211, 221) der Leistungstransistoren (210, 220) des Unterbrechers verbunden zu werden, und jeweils einen Sperrunterbrecher (SW_{CHG}, SW_{DISCHG}; 511, 512) umfassen, der ermöglicht, den entsprechenden Leistungstransistor (210, 220) in den "AUS"-Zustand zu versetzen, **dadurch gekennzeichnet, dass** jeder der Zweige (500a, 500b) außerdem einen ersten Schutztransistor (501a, 501b) und einen zweiten Schutztransistor (502a, 502b) umfasst, die zwischen dem Gate (211, 221) des entsprechenden Leistungstransistors (210, 220) und dem Sperrunterbrecher (SW_{CHG}, SW_{DISCHG}; 511, 512) in Reihe geschaltet sind, wobei das Kopplungsmittel (SW_{CPL}, 510) zwischen dem Verbindungsknoten des ersten und des zweiten Schutztransistors (501a, 502a) des ersten Zweigs (500a) und dem Verbindungsknoten des ersten und des zweiten Schutztransistors (501 b, 502b) des zweiten Zweigs (500b) geschaltet ist.

2. Steuersystem nach Anspruch 1, **dadurch gekennzeichnet, dass** die Steuermittel (50) zwei Ladungspumpen (510, 520) umfassen, die jeweils dazu vorgesehen sind, mit dem Gate (211, 221) des entsprechenden Leistungstransistors (210, 220) verbunden zu werden.

3. Steuersystem nach Anspruch 1, **dadurch gekennzeichnet, dass** die Sperrunterbrecher (SW_{CHG}, SW_{DISCHG}; 511, 512) MOSFET-Transistoren sind.

4. Steuersystem nach einem der vorhergehenden Ansprüche, **dadurch gekennzeichnet, dass** das Kopplungsmittel ein MOSFET-Transistor ist.

5. Verfahren zum Steuern eines bidirektionalen Unterbrechers (20), der aus einem Paar von Leistungs-MOSFET-Transistoren (210, 220), die in Antireihe, Source mit Source oder Drain mit Drain, geschaltet sind und durch Steuermittel (50) eines Steuersystems nach einem der vorhergehenden Ansprüche gesteuert werden, gebildet ist, wobei der eine oder der andere der Leistungstransistoren (210, 220) in den "AUS"-Zustand versetzt werden kann, um die Unterbrechung eines Stroms (I_{CHG}, I_{DISCHG}) durch den Unterbrecher (20) sicherzustellen, wobei in dem Verfahren bei der Auslösung des Unterbrechers (20) das Gate (211; 221) des Transistors im "EIN"-Zustand wenigstens vorübergehend mit dem Gate (221; 211) des Transistors im "AUS"-Zustand verbunden wird.

6. Steuerverfahren nach Anspruch 5, bei dem die Gates (211, 221) der Leistungstransistoren (210, 220) ständig verbunden sind, wenn jene im "EIN"-Zustand sind.
